# EUROPÄISCHE PATENTSCHRIFT

(11) **EP 3 108 722 B1**
(45) Veröffentlichungstag und Bekanntmachung des Hinweises auf die Patenterteilung: **13.05.2020**
(21) Anmeldenummer: 15705005.5
(22) Anmeldetag: 12.02.2015
(51) Int. Cl.: H05K 1/14

(54) **LEITERPLATTE MIT SPEZIELLEN KUPPLUNGSBEREICHEN**
PRINTED CIRCUIT BOARD COMPRISING SPECIFIC COUPLING REGIONS
CARTE DE CIRCUITS IMPRIMÉS COMPORTANT DES ZONES DE COUPLAGE SPÉCIALES

(30) Priorität: 17.02.2014 DE 202014100686 U
(43) Veröffentlichungstag der Anmeldung: 28.12.2016
(73) Patentinhaber: Zumtobel Lighting GmbH, 6850 Dornbirn (AT)
(72) Erfinder: FAVAROLO, Angelo, Dott., 88239 Wangen im Allgäu (DE)
(74) Vertreter: Kiwit, Benedikt
(86) Internationale Anmeldenummer: PCT/EP2015/052910
(87) Internationale Veröffentlichungsnummer: WO 2015/121325

(56) Entgegenhaltungen:
- DE-U1-202013 008 407
- JP-A- H1 131 890
- JP-A- 2001 203 314
- JP-A- 2005 243 970
- JP-A- 2012 253 213
- US-A1- 2011 068 709
- US-A1- 2011 101 384
- US-A1- 2012 021 657
- US-A1- 2013 146 937
- US-B1- 6 981 878

## Beschreibung

### 1. Gebiet der Erfindung

Die vorliegende Erfindung betrifft eine (lineare) Leiterplatte zur Aufnahme zumindest einer Leuchtdiode und eine Leiterplattenanordnung, wie insbesondere ein Beleuchtungsmittel.

### 2. Hintergrund

Aus dem Stand der Technik ist eine Vielzahl von Leiterplatten zur Aufnahme von Leuchtdioden bekannt. Bei derartigen Leiterplatten besteht allgemein das Bedürfnis, die durch die Leuchtdiode im Betrieb erzeugte Wärme effektiv abzuführen, um eine effiziente und langlebige Lichtabgabe durch die Leuchtdiode zu ermöglichen.

Die Druckschriften JP 2012 - 253 213 A und JP 2001 - 203 314 A offenbaren jeweils die Bereitstellung einer Verbindungsstruktur eines Verdrahtungs- bzw. Halbleiterkörpers zur elektrischen Verbindung mit weiteren solcher Körper.

Allgemein besteht daher die Tendenz, die auf den Leiterplatten aufgebrachten Leiterbahnen möglichst großflächig auszuführen, da diese Leiterbahnen üblicherweise aus Kupfer gebildet werden, und somit eine vergleichsweise hohe Wärmeleitfähigkeit zur Verfügung stellen, um die durch die Leuchtdioden anfallende Wärme abzutransportieren. Ferner ist bekannt, verschiedene Kühlkörper an den Leiterplatten anzuordnen, um die durch die Leuchtdioden hervorgerufene Wärme zusätzlich abzuführen.

Die DE202013008407U1 offenbart eine Verbindung von Leiterplatten mittels in den Leiterplatten vorgesehenen Zapfen und Bohrungen so mechanische und gleichzeitig elektrischen Verbindung.

Ein weiterer Aspekt, der bei der Konstruktion von Leiterplatten für Leuchtdioden zu beachten ist, ist das zwischen den einzelnen leitenden Bereichen ein Mindestabstand vorzusehen ist, um unbeabsichtigte Kurzschlüsse zu vermeiden. Dabei kann es einerseits zu einer sogenannten Kriechentladung und andererseits zu einem Luftkurzschluss zwischen benachbarten leitenden Bereichen kommen. Dieser Mindestabstand zwischen zwei benachbarten leitenden Bereichen wird daher als sogenannte Luft- und Kriechstrecke bezeichnet. Wird die Leiterplatte an einem leitenden Kühlkörper angeordnet, so muss zwischen den Leiterbahnen und dem Außenumfang der Leiterplatte ebenfalls eine Luft- und Kriechstrecke vorgesehen werden. Üblicherweise wird zwischen den Leiterbahnen und dem Außenumfang einer Leiterplatte eine Luft- und Kriechstrecke in Form eines Isolationsbereichs in einer Größenordnung zwischen 2 und 3 mm vorgesehen, um einen unbeabsichtigten Kurzschluss über den Kühlkörper zu verhindern.

Werden Leiterplatten, die im Randbereich eine übliche Luft- und Kriechstrecke zwischen 2 und 3 mm aufweisen, hintereinander bzw. in Serie geschalten, um beispielsweise eine großflächige Beleuchtungsvorrichtung zu bilden, addieren sich die Luft- und Kriechstrecken im Verbindungsbereich. Mit anderen Worten verdoppelt sich im Verbindungsbereich von zwei Leiterplatten die Luft- und Kriechstrecke zwischen den Leiterbahnen zweier benachbarter Leiterplatten üblicherweise auf 4 bis 6 mm.

Diese Verdopplung der Luft- und Kriechstrecke zwischen zwei benachbarten Leiterplatten führt dazu, dass in den Verbindungsbereichen zweier Leiterplatten der Wärmeabtransport weniger effizient erfolgt, da die wärmeabführenden Leiterbahnen dadurch relativ weit voneinander beabstandet werden.

Ferner führt die Verdopplung der Luft- und Kriechstrecke in den Verbindungsbereichen zweier Leiterplatten dazu, dass die Leuchtdioden nicht mehr regelmäßig verteilt sind, und sich für den Benutzer daher ein inhomogener Beleuchtungseindruck ergeben kann.

Ausgehend von diesem Stand der Technik stellt sich die vorliegende Erfindung die Aufgabe, eine Leiterplatte für Leuchtdioden bereitzustellen, die eine ausreichende Luft- und Kriechstrecke zwischen den Leiterbahnen und dem Außenumfang bereitstellt, und zwar sowohl im verbundenen Zustand zweier Leiterplatten als auch für den Fall, dass die Leiterplatte alleine verwendet wird.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### 3. Ausführliche Beschreibung der Erfindung

Die erfindungsgemäße Leiterplatte dient zur Aufnahme zumindest einer Leuchtdiode und umfasst zumindest an einer Seite einen Isolationsbereich, der eine Luft- und Kriechstrecke zwischen den auf der Leiterplatte angeordneten Leiterbahnen und dem Außenumfang der Leiterplatte bereitstellt. Erfindungsgemäß weist dabei zumindest einer der Isolationsbereiche zumindest ein Feder-Nut-Mittel auf, das mit einem korrespondierenden Feder-Nut-Mittel einer weiteren Leiterplatte derart in Eingriff gebracht werden kann, dass sich die jeweiligen die Luft- und Kriechstrecken bereitstellenden Isolationsbereiche zumindest teilweise überlappen.

Ein erfindungsgemäßes Feder-Nut-Mittel kann dabei in einer einfachen Ausführungsform als gerade Zunge und als Hinterschneidung, in die eine korrespondierende gerade Zunge einer weiteren Leiterplatte eingeschoben werden kann, bereitgestellt werden. Im Querschnitt betrachtet sind die Feder-Nut-Mittel somit stufenförmig ausgebildet, wobei Feder und Nut vorzugsweise jeweils die Hälfte des Leiterplattenquerschnitts bzw. Leiterplattendicke umfassen. Beim Verbinden zweier Leiterplatten wird eine gerade Zunge der einen Leiterplatte in die korrespondierende Hinterschneidung der anderen Leiterplatte eingeschoben und umgekehrt. Mit anderen Worten werden die Isolationsbereiche bzw. die Luft- und Kriechstrecken zweier benachbarter Leiterplatten nicht mehr aneinander gereiht sondern ineinander geschoben.

Denkbar sind auch komplexere Strukturen der Feder-Nut-Mittel, solange diese derart ausgebildet sind, dass korrespondierende Feder-Nut-Mittel zweier Leiterplatten ineinandergreifen können und sich teilweise überlappen können. Anders als bei der genannten einfachen stufenförmigen Ausgestaltung der Feder-Nut-Mittel können auch Feder-Nut-Mittel vorgesehen werden, die darüber hinaus auch ein vertikales und/oder horizontales Verschieben der Leiterplatten im verbundenen Zustand relativ zueinander verhindern. Dies kann beispielsweise durch einen im Querschnitt betrachtet mittig angeordnete Feder und einer korrespondierenden mittig angeordneten Nut erfolgen.

Durch die Ausbildung des Isolationsbereichs mit/als Feder-Nut-Mittel besteht somit die Möglichkeit, eine sonst übliche Verdopplung der Luft- und Kriechstrecke zwischen zwei benachbarten Leiterplatten zu verhindern oder jedenfalls erheblich zu reduzieren.

Wird eine erfindungsgemäße Leiterplatte hingegen einzeln, d.h. nicht in Kombination mit einer weiteren Leiterplatten verwendet, kann dennoch eine ausreichend Luft- und Kriechstrecke bereitgestellt werden, da in diesem Fall die Feder-Nut-Mittel als Luft- und Kriechstrecke dienen.

Ein erfindungsgemäßes Feder-Nut-Mittel erlaubt somit ein Ineinanderschieben zweier benachbarter Leiterplatten derart, dass diese eine kombinierte Luft- und Kriechstrecke bereitstellen, die eine im Vergleich zum Stand der Technik reduzierte Ausdehnung aufweist.

Durch das Ineinandergreifen zweier korrespondierender Feder-Nut-Mittel benachbarter Leiterplatten werden auch die Leiterbahnen benachbarter Leiterplatten näher zueinander positioniert, so dass aufgrund der höheren Wärmeleitfähigkeit der Leiterbahnen auch die anfallende Wärme beim Betrieb der Leuchtdioden effektiver aus den Rand- bzw. Verbindungsbereichen der Leiterplatten abtransportiert werden kann.

Dieser effektivere Abtransport der Wärme wirkt sich einerseits positiv auf die Lebensdauer der im Randbereich angeordneten Leuchtdioden aus und andererseits auch auf die Lichtausbeute, die bei Leuchtdioden stark temperaturabhängig ist.

Schließlich können durch das Ineinandergreifen korrespondierender Feder-Nut-Mittel, und der damit entsprechenden Reduzierung der Luft- und Kriechstrecke zwischen zwei benachbarten Leiterplatten, die Leuchtdioden zweier benachbarter Leiterplatten mit der gewünschten regelmäßigen Beabstandung bereitgestellt werden bzw. mit einer wesentlich kleineren Abweichung der jeweiligen Abstände zwischen den Leuchtdioden. Dadurch ergibt sich für den Benutzer ein homogener Lichteindruck, ohne störende Beleuchtungsfehler in den Verbindungsbereichen zweier Leiterplatten.

In einer bevorzugten Ausführungsform beträgt der die Luft- und Kriechstrecke bereitstellende Isolationsbereich zwischen den auf der Leiterplatte angeordneten Leiterbahnen und dem Außenumfang der Leiterplatte zwischen 1 mm und 5 mm, bevorzugt zwischen 1,5 und 4 mm und besonders bevorzugt zwischen 2 und 3 mm.

Aufgrund der oft eingesetzten hohen Spannung beträgt die (Mindest-)Länge der Luft- und Kriechstrecke einer Leiterplatte in der Praxis üblicherweise zwischen 2 und 3 mm. Diese Größenordnung der Luft- und Kriechstrecke ist insbesondere dann zu wählen, wenn an der Rückseite der Leiterplatte ein metallischer Kühlkörper vorgesehen ist. Mit der erfindungsgemäßen Leiterplatte kann somit bei einer Luft- und Kriechstrecke bzw. einem Isolationsbereich einer Leiterplatte von 3 mm verhindert werden, dass eine kombinierte Luft- und Kriechstrecke im Verbindungsbereich zweier Leiterplatten von 6 mm entsteht.

Bevorzugt weist das Feder-Nut-Mittel im Wesentlichen dieselbe Länge bzw. Breite (also die Erstreckung von der das Feder-Nut-Mittel aufweisenden Stirnseite der Leiterplatte zu der (nächstliegenden) Leiterbahn hin) auf wie der Isolationsbereich, d.h. das Feder-Nut-Mittel nimmt im Wesentlichen den gesamten Isolationsbereich ein. Dadurch besteht die Möglichkeit, einen relativ großen Bereich für die Feder bzw. die Nut bereitzustellen, was wiederum die Stabilität zweier verbundener Leiterplatten erhöht.

Von der nächstliegenden Leiterbahn der Leiterplatte bis zum benachbarten Feder-Nut-Mittel ist lediglich ein geringfügiger Bereich (Schutzbereich) vorzugsweise zwischen 0,1 und 0,8 mm, besonders vorzugsweise zwischen 0,3 und 0,6 mm des Isolationsbereichs (in Richtung von dem Feder-Nut-Mittel zur nächstliegenden Leiterbahn hin) freizuhalten, damit beim Zusammenfügen zweier Leiterplatten keine Beschädigungen der Leiterbahnen durch die Feder eines korrespondieren Feder-Nut-Mittels einer weiteren Leiterplatte auftreten können.

In einer bevorzugten Ausführungsform weist die Leiterplatte in Draufsicht auf die Leiterplatte eine im Wesentlichen rechteckige Form auf. Es sollte dem Fachmann klar sein, dass Feder-Nut-Mittel auch an anderen Leiterplattengeometrien vorgesehen werden können, um dadurch eine Verdopplung der Luft- und Kriechstrecke beim Aneinanderfügen von mehreren Leiterplatten zu verhindern.

Bevorzugt werden an zumindest zwei gegenüberliegenden Seiten der Leiterplatte entsprechende Feder-Nut-Mittel vorgesehen. Bei Verwendung von länglichen Leiterplatten beispielsweise zur Ausbildung eines länglichen Beleuchtungsmittels können dadurch mehrere Leiterplatten jeweils stirnseitig miteinander mit ihren jeweiligen korrespondieren Feder-Nut-Mitteln in Eingriff gebracht werden.

In einer besonders bevorzugten Ausführungsform sind an vier Seiten der Leiterplatte Feder-Nut-Mittel vorgesehen. Dadurch besteht die Möglichkeit, Leiterplatten - insbesondere rechteckige Leiterplatten - großflächig bzw. matrixartig aneinanderzufügen, um beispielsweise ein großflächiges Beleuchtungsmittel zu bilden.

Vorzugsweise sind an zumindest einem der Feder-Nut-Mittel Rastmittel vorgesehen, die mit einem korrespondierenden Rastmittel eines korrespondierenden Feder-Nut-Mittels einer weiteren Leiterplatte verrastbar sind. Ein solches Rastmittel kann beispielsweise durch einen Zapfen oder eine Wulst, der/die an der Feder vorgesehen ist, und einer korrespondieren Aufnahme an der Feder der weiteren Leiterplatte bereitgestellt werden. Dadurch besteht eine einfache Möglichkeit, eine Fixierung der Leiterplatten zueinander in horizontaler Richtung bereitzustellen.

### 4. Beschreibung von bevorzugten Ausführungsformen

Im Folgenden wird eine detaillierte Beschreibung der Figuren gegeben. Darin zeigt:
- Figur 1: eine schematische Ansicht einer im Stand der Technik bekannten Leiterplatte zur Aufnahme von Leuchtdioden;
- Figur 2: zwei hintereinander angeordneten Leiterplatten nach Figur 1;
- Figur 3: eine schematische Ansicht von zwei erfindungsgemäßen Leiterplatten, die eine erfindungsgemäße Leiterplattenanordnung bildet; und
- Figur 4: eine schematische Ansicht einer weiteren Ausführungsform einer erfindungsgemäßen Leiterplattenanordnung mit alternativen Feder-Nut-Mitteln.

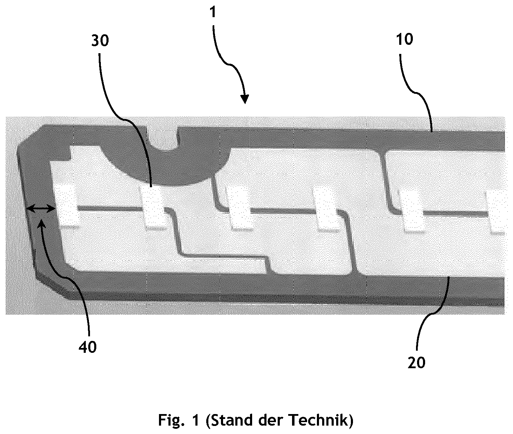

In Figur 1 ist eine im Stand der Technik bekannte Leiterplatte 1 zur Aufnahme von Leuchtdioden in schematischer Ansicht gezeigt.

Die Leiterplatte 1 weist dabei in Draufsicht eine im Wesentlichen rechteckige Form auf. In der gezeigten Ausführungsform weist die Leiterplatte 1 ein Trägermaterial 10 auf, das aus einem geeigneten elektrisch isolierenden Material, wie Phenol- oder Epoxidharze, besteht, mehreren auf dem Trägermaterial 10 angeordnete Leiterbahnen 20, die aus einem geeigneten elektrisch leitfähigem Material, wie beispielsweise Kupfer, gebildet sind und schließlich mehrere Anschlusspads 30, an der verschiedene Leuchtdioden (oder auch andere elektronische Bauteile) angeschlossen werden können.

Die gezeigte Leiterplatte 1 weist dabei im Stirnbereich, d.h. zwischen dem Außenumfang und der benachbarten Leiterbahn 20, einen eine Luft- und Kriechstrecke bereitstellenden Isolationsbereich 40 von ca. 3 mm auf, um eine ungewollte Entladung über die Luft bzw. das Trägermaterial zu verhindern.

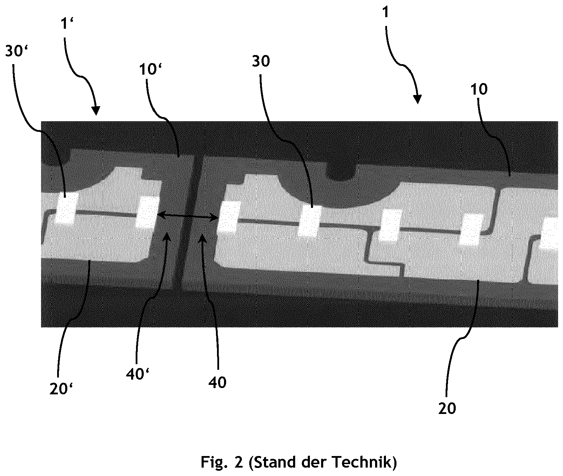

Figur 2 zeigt eine schematische Darstellung von zwei hintereinander angeordneten Leiterplatten 1, 1' aus Figur 1. Gleiche Teile sind mit identischen Bezugszeichen versehen.

Wie in Figur 2 besonders gut zu erkennen, verdoppelt sich beim stirnseitigen Verbinden der Leiterplatten 1, 1' die durch die jeweiligen Luft- und Kriechstrecken 40, 40' gebildete kombinierte Luft- und Kriechstrecke. Somit ergibt sich im Verbindungsbereich eine kombinierte Luft- und Kriechstrecke von ca. 6 mm (ca. 3mm + ca. 3 mm).

Nachdem das Trägermaterial 10, 10' üblicherweise aus schlecht wärmeleitenden Harzen gebildet wird, kann im Übergangsbereich der Leiterplatten 1, 1' die Wärme nicht effizient abgeführt werden, da die jeweils benachbarten Leiterbahnen 20, 20' relativ weit voneinander beabstandet angeordnet sind. Wie bereits oben erläutert, bestehen die Leiterbahnen üblicherweise aus einer Kupferlegierung, die einen effektiven Wärmeabtransport bereitstellen. Durch die Verdopplung der kombinierten Luft- und Kriechstrecke und somit der entsprechende Isolationsbereich wird darüber hinaus auch die gewünschte regelmäßige Anordnung der Leuchtdioden erschwert bzw. verhindert.

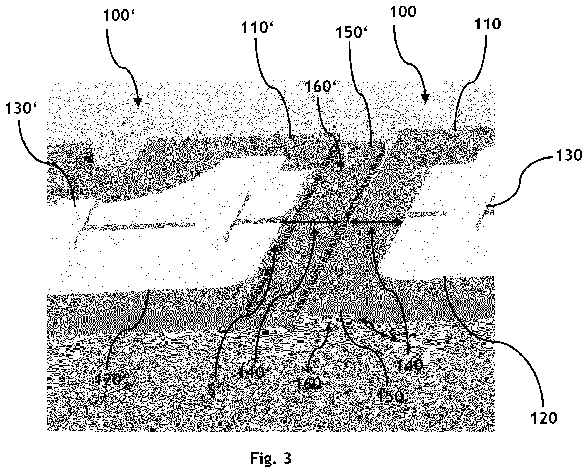

Figur 3 zeigt eine schematische Ansicht von zwei hintereinander angeordneten erfindungsgemäßen Leiterplatten 100, 100'.

Die gezeigten Leiterplatten 100, 100' weisen in Draufsicht eine im Wesentlichen längliche Rechteckform auf. Diese Form wird insbesondere dann verwendet, um längliche Beleuchtungsmittel bereitzustellen.

Die Leiterplatten 100, 100' umfassen ebenfalls ein nichtleitfähiges Trägermaterial 110, 110', Leiterbahnen 120, 120' und elektrischen Kontaktierungen (bspw. Anschlusspads 130, 130' für Leuchtdioden (nicht gezeigt)).

Erfindungsgemäß umfassen die Leiterplatten 100, 100' in ihren jeweiligen Stirnbereichen stufenförmig ausgebildete Feder-Nut-Mittel, jeweils in Form einer Feder 150, 150' und einer jeweils zur Aufnahme einer korrespondieren Feder 150, 150' ausgebildeten Nut 160, 160'.

Wie in Figur 3 gut zu erkennen, sind die Feder-Nut-Mittel korrespondierend ausgebildet, d.h. die Feder 150 der rechts gezeigten Leiterplatte 100 kann in die Nut 160' der links gezeigten Leiterplatte 100' eingeführt werden und die Feder 150' der links gezeigten Leiterplatte 100' kann in die Nut 160 der rechts gezeigten Leiterplatte 100 eingeführt werden.

Vorliegend ist eine Kombination von wenigstens zwei erfindungsgemäßen Leiterplatten als erfindungsgemäße Leiterplattenanordnung zu verstehen, wobei eine mit Leuchtmitteln versehene Leiterplattenanordnung ein erfindungsgemäßes Beleuchtungsmittel bildet.

Im gezeigten Ausführungsbeispiel nehmen die jeweiligen Federn 150, 150' in etwa die Hälfte der Materialdicke des Trägermaterials 110, 110' ein, korrespondierend hierzu nimmt die jeweilige Nut 160, 160' ebenfalls in etwa die Hälfte der Dicke des Trägermaterials 110, 110' ein.

Wie in Figur 3 zu erkennen, wird beim Verbinden der zwei Leiterplatten 100, 100' eine kombinierte Luft- und Kriechstrecke gebildet, die im Wesentlichen der Länge einer Luft- und Kriechstrecke bzw. der Breite eines Isolationsbereichs 140, 140' einer Leiterplatte 100, 100' entspricht. Zu erkennen ist ebenfalls, dass die jeweiligen Feder-Nut-Mittel vorzugsweise einen nicht unmittelbar bis zu den jeweils benachbarten Leiterbahnen 120, 120' bzw. Anschlusspads 130, 130' reichen, sondern ca. 0,1 bis 0,6 mm beabstandet hiervon ausgebildet sind, um eine Beschädigung der Leiterbahnen 120, 120' bzw. der Anschlusspads 130, 130' beim Ineinanderschieben der jeweiligen Feder-Nut-Mittel zu verhindern. Vorzugsweise ist hierzu ein sich von der nächstliegenden Leiterbahn 120, 120' der Leiterplatte 100, 100' bis zu dem benachbarten Feder-Nut-Mittel der Isolationsbereich 140, 140' erstreckender Schutzbereich S, S' vorgesehen.

In der gezeigten Ausführungsform der Feder-Nut-Mittel verhindern diese nicht, dass die Leiterplatten 100, 100' vertikal oder horizontal zueinander verschoben werden können. Dies ist insbesondere dann von Vorteil, wenn großflächige, mosaikartige Beleuchtungsflächen gebildet werden sollen, da in diesem Fall Leiterplatten beliebig vertikal eingefügt bzw. ausgetauscht werden können.

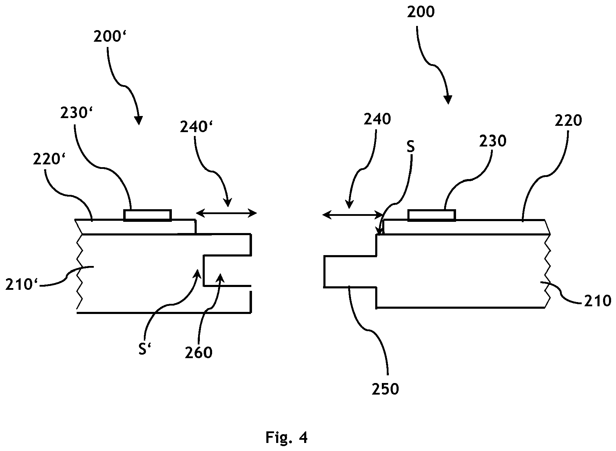

Figur 4 zeigt eine schematische Darstellung erfindungsgemäßer Leiterplatten 200, 200', die ebenfalls ein Trägermaterial 210, 210' und darauf angeordnete Leiterbahnen 220, 220' und Anschlusspads 230, 230' umfassen.

Die gezeigten Leiterplatten 200, 200' umfassen dabei alternativ ausgebildete Feder-Nut-Mittel; im Übrigen gilt dasselbe wie für die zuvor beschriebene erste Ausführungsform der Leiterplatten 100, 100'. Wie in Figur 4 zu erkennen, weist die rechts gezeigte Leiterplatte 200 im Stirnbereich, also im Isolationsbereich 240, eine bezüglich des Querschnittes mittig angeordnete Feder 250 auf, die in eine mittig angeordnete Nut 260 des Feder-Nut-Mittels des Isolationsbereichs 240' der links gezeigten Leiterplatte 200' eingeführt werden kann.

Im Vergleich zu den in Figur 3 gezeigten Feder-Nut-Mitteln verhindern die in Figur 4 gezeigten Feder-Nut-Mittel im verbundenen Zustand ein vertikales Verschieben der Leiterplatten 200, 200' zueinander. Eine solche Ausführungsform der Feder-Nut-Mittel kann insbesondere bei vergleichsweise dickeren Leiterplatten von Vorteil sein, um die Steifigkeit bzw. die Stabilität der durch die Leiterplatten gebildeten Beleuchtungsfläche zu erhöhen.

Ferner kann es von Vorteil sein, die oben gezeigten Feder-Nut-Mittel mit zusätzlichen Rastmitteln zu versehen, um die Leiterplatten in horizontaler Richtung zueinander zu sichern. Dies kann beispielsweise durch Rastzungen, die an den Federn vorgesehen werden und entsprechend korrespondierenden Aufnahmen an der weiteren Leiterplatte bereitgestellt werden.

Die Erfindung ist nicht auf die vorhergehenden Ausführungsbeispiele beschränkt, solange sie vom Gegenstand der folgenden Ansprüche umfasst ist. Ferner sind die vorhergehenden Ausführungsbeispiele in beliebiger Weise miteinander kombinierbar. So kann die Leiterplatte beispielsweise jede beliebige Form aufweisen, solange sie mit entsprechenden Feder-Nut-Mitteln auf einer oder mehreren anderen Leiterplatten entsprechend verbindbar ist. Auch ist die Ausgestaltung (Form, Dimension, etc.) der Feder-Nut-Mittel nicht durch die Erfindung beschränkt, solange sie ein Verbinden zweier oder mehrerer Leiterplatten ermöglicht. In der Regel erstrecken sich die jeweiligen Feder-Nut-Mittel hierbei in der Leiterplattenebene von der jeweiligen Stirnseite der Leiterplatte (weg). Es ist auch denkbar, dass an einer Stirnseite unterschiedliche Feder-Nut-Mittel vorgesehen sind, um darüber mit einer oder mehreren korrespondierenden Leiterplatten verbunden zu werden.

## Patentansprüche

1. Leiterplatte (100, 100'; 200, 200') zur Aufnahme zumindest einer Leuchtdiode, umfassend: zumindest an einer Seite der Leiterplatte einen Isolationsbereich (140, 140'; 240, 240'), der eine Luft- und Kriechstrecke zwischen den auf der Leiterplatte (100, 100'; 200, 200') angeordneten Leiterbahnen (120, 120'; 220, 220') und dem Außenumfang der Leiterplatte (100, 100'; 200, 200') bereitstellt, **dadurch gekennzeichnet, dass** zumindest einer der Isolationsbereiche (140, 140'; 240, 240') ein Feder-Nut-Mittel (150, 160, 150', 160'; 250, 260) aufweist, das mit einem korrespondierenden Feder-Nut-Mittel (150, 160, 150', 160'; 250, 260) einer weiteren Leiterplatte (100, 100'; 200, 200') derart in Eingriff bringbar ist, dass sich die jeweiligen die Luft- und Kriechstrecken bereitstellenden Isolationsbereiche (140, 140'; 240, 240') zumindest teilweise überlappen.

2. Leiterplatte (100, 100'; 200, 200') nach Anspruch 1, **dadurch gekennzeichnet, dass** der die Luft- und Kriechstrecke bereitstellende Isolationsbereich (140, 140'; 240, 240') zwischen den auf der Leiterplatte (100, 100'; 200, 200') angeordneten Leiterbahnen (120, 120'; 220, 220') und dem Außenumfang der Leiterplatte (100, 100'; 200, 200') zwischen 1 mm und 5 mm beträgt.

3. Leiterplatte (100, 100'; 200, 200') nach einem der Ansprüche 1 oder 2, **dadurch gekennzeichnet, dass** die Feder (150, 150'; 250) und/oder die Nut (160, 160'; 260) des Feder-Nut-Mittels (150, 160, 150', 160'; 250, 260) eine Breite von der das entsprechende Feder-Nut-Mittel aufweisenden Stirnseite der Leiterplatte zu der Leiterbahn (120, 120'; 220, 220') hin zwischen 1 mm und 5 mm aufweisen.

4. Leiterplatte (100, 100'; 200, 200') nach einem der vorhergehenden Ansprüche, **dadurch gekennzeichnet, dass** von der nächstliegenden Leiterbahn (120, 120'; 220, 220') der Leiterplatte (100, 100'; 200, 200') bis zu dem benachbarten Feder-Nut-Mittel der Isolationsbereich (140, 140'; 240, 240') einen Schutzbereich (S, S') aufweist, um eine mechanische Beschädigung der entsprechenden Leiterbahn (120, 120'; 220, 220') zu vermeiden.

5. Leiterplatte (100, 100'; 200, 200') nach einem der vorhergehenden Ansprüche, **dadurch gekennzeichnet, dass** die Feder-Nut-Mittel (150, 160, 150', 160') stufenförmig ausgebildet sind, wobei Feder (150, 150') und Nut (160, 160') jeweils die Hälfte des Leiterplattenquerschnitts bzw. Leiterplattendicke umfassen.

6. Leiterplatte (100, 100'; 200, 200') nach einem der vorhergehenden Ansprüche, **dadurch gekennzeichnet, dass** die Feder-Nut-Mittel (250, 260) zweier verbundener Leiterplatten (100, 100'; 200, 200') derart miteinander in Eingriff stehen, dass ein vertikales und/oder horizontales Verschieben der verbundenen Leiterplatten (100, 100'; 200, 200') verhindert wird.

7. Leiterplatte (100, 100'; 200, 200') nach einem der vorhergehenden Ansprüche, **dadurch gekennzeichnet, dass** die Leiterplatte (100, 100'; 200, 200') in Draufsicht eine im Wesentlichen rechteckige Form aufweist.

8. Leiterplatte (100, 100'; 200, 200') nach einem der vorhergehenden Ansprüche, **dadurch gekennzeichnet, dass** an zumindest zwei Seiten der Leiterplatte (100, 100'; 200, 200') Feder-Nut-Mittel (150, 160, 150', 160'; 250, 260) vorgesehen sind.

9. Leiterplatte (100, 100'; 200, 200') nach Anspruch 8, **dadurch gekennzeichnet, dass** an allen Seiten der Leiterplatte (100, 100'; 200, 200') Feder-Nut-Mittel (150, 160, 150', 160'; 250, 260) vorgesehen sind.

10. Leiterplatte (100, 100'; 200, 200') nach einem der vorhergehenden Ansprüche, **dadurch gekennzeichnet, dass** an zumindest einem der Feder-Nut-Mittel (150, 160, 150', 160'; 250, 260) Rastmittel vorgesehen sind, die mit einem korrespondierenden Rastmittel eines korrespondierenden Feder-Nut-Mittels (150, 160, 150', 160'; 250, 260) einer weiteren Leiterplatte (100, 100'; 200, 200') verrastbar ist.

11. Leiterplatte (100, 100'; 200, 200') nach einem der vorhergehenden Ansprüche, **dadurch gekennzeichnet, dass** die Leiterplatte (100, 100'; 200, 200') keine flexible Leiterplatte ist.

12. Leiterplattenanordnung, umfassend zumindest zwei Leiterplatten (100, 100'; 200, 200') nach einem der Ansprüche 1 bis 11, bei denen korrespondierende Feder-Nut-Mittel (150, 160, 150', 160'; 250, 260) miteinander in Eingriff stehen, so dass sich die jeweiligen die Luft- und Kriechstrecken bereitstellenden Isolationsbereiche (140, 140'; 240, 240') zumindest teilweise überlappen.

13. Leiterplattenanordnung nach Anspruch 12, wobei die durch die zumindest zwei Leiterplatten (100, 100'; 200, 200') gebildete Luft- und Kriechstrecke der sich überlappenden Isolationsbereiche (140, 140'; 240, 240') zwischen den Leiterbahnen (120, 120'; 220, 220') der zumindest zwei Leiterplatten (100, 100'; 200, 200') 1 mm und 5 mm beträgt.

14. Beleuchtungsmittel, umfassend eine Leiterplattenanordnung nach einem der Ansprüche 12 oder 13, wobei die Leiterplatten jeweils wenigstens ein Leuchtmittel aufweisen.

## Claims

1. A printed circuit board (100, 100', 200, 200') for accommodating at least one light emitting diode, comprising: An insulating region (140, 140'; 240, 240') at least on one side of the printed circuit board, which insulating region provides an air gap and leakage path between the conductor tracks (120, 120'; 220, 220') arranged on the printed circuit board (100, 100'; 200, 200') and the outer periphery of the printed circuit board (100, 100'; 200, 200'), **characterized in that** at least one of the insulating regions (140, 140'; 240, 240') has a tongue and groove means (150, 160, 150', 160'; 250, 260), which can be brought into engagement with a corresponding tongue and groove means (150, 160, 150', 160'; 250, 260) of a further printed circuit board (100, 100'; 200, 200') in such a manner that the respective insulating regions (140, 140'; 240, 240') providing the air gaps and leakage paths at least partially overlap.

2. The printed circuit board (100, 100'; 200, 200') according to Claim 1, **characterized in that** the insulating region (140, 140'; 240, 240') providing the air gap and leakage path between the conductor tracks (120, 120'; 220, 220') arranged on the printed circuit board (100, 100'; 200, 200') and the outer periphery of the printed circuit board (100, 100'; 200, 200') is between 1 mm and 5 mm.

3. The printed circuit board (100, 100'; 200, 200') according to any one of Claims 1 or 2, **characterized in that** the tongue (150, 150'; 250) and/or the groove (160, 160'; 260) of the tongue and groove means (150, 160, 150', 160'; 250, 260) have a width from the end face of the printed circuit board having the corresponding tongue and groove means to the printed conductor path (120, 120'; 220, 220') between 1 mm and 5 mm.

4. The printed circuit board (100, 100'; 200, 200') according to any one of the preceding claims, **characterized in that** the insulating region (140, 140'; 240, 240') has a protective region (S, S') from the closest conductor track (120, 120'; 220, 220') of the printed circuit board (100, 100'; 200, 200') to the adjacent tongue and groove means of the insulating region (140, 140'; 240, 240'), in order to prevent mechanical damage to the corresponding conductor track (120, 120'; 200, 220').

5. The printed circuit board (100, 100'; 200, 200') according to any one of the preceding claims, **characterized in that** the tongue and groove means (150, 160, 150', 160') are designed in a step-shaped manner, wherein tongue (150, 150') and groove (160, 160') in each case comprise half of the cross section of the printed circuit board or thickness of the printed circuit board.

6. The printed circuit board (100, 100'; 200, 200') according to any one of the preceding claims, **characterized in that** the tongue and groove means (250, 260) of two connected printed circuit boards (100, 100'; 200, 200') are engaged with one another in such a manner that a vertical and/or horizontal displacement of the connected printed circuit boards (100, 100'; 200, 200') is prevented.

7. The printed circuit board (100, 100'; 200, 200') according to any one of the preceding claims, **characterized in that** the printed circuit board (100, 100'; 200, 200') has a substantially rectangular form in a top view.

8. The printed circuit board (100, 100'; 200, 200') according to any one of the preceding claims, **characterized in that** tongue and groove means (150, 160, 150', 160'; 250, 260) are provided on at least two sides of the printed circuit board (100, 100'; 200, 200').

9. The printed circuit board (100, 100'; 200, 200') according to Claim 8, **characterized in that** tongue and groove means (150, 160, 150', 160'; 250, 260) are provided on all sides of the printed circuit board (100, 100'; 200, 200').

10. The printed circuit board (100, 100'; 200, 200') according to any one of the preceding claims, **characterized in that** on at least one of the tongue and groove means (150, 160, 150', 160'; 250, 260) latching means are provided, which can be latched with a corresponding latching means of a corresponding tongue and groove means (150, 160, 150', 160'; 250, 260) to a further printed circuit board (100, 100'; 200, 200').

11. The printed circuit board (100, 100'; 200, 200') according to any one of the preceding claims, **characterized in that** the printed circuit board (100, 100'; 200, 200') is not a flexible printed circuit board.

12. A printed circuit board arrangement, comprising at least two printed circuit boards (100, 100'; 200, 200') according to any one of Claims 1 to 11, in which corresponding tongue and groove means (150, 160, 150', 160'; 250, 260) are engaged with one another, so that the respective insulating regions (140, 140'; 240, 240') providing the air gaps and leakage paths at least partially overlap.

13. The printed circuit board arrangement according to Claim 12, wherein the air gap and leakage path of the overlapping insulating regions (140, 140'; 240, 240') formed by the at least two printed circuit boards (100, 100'; 200, 200') between the printed conductor tracks (120, 120'; 220, 220') of the at least two printed circuit boards (100, 100'; 200, 200') is 1 mm and 5 mm.

14. An illumination means, comprising a printed circuit board arrangement according to any one of Claims 12 or 13, wherein the printed circuit boards in each case have at least one light-emitting means.

## Revendications

1. Carte de circuit imprimé (100, 100' ; 200, 200') destinée à recevoir au moins une diode électroluminescente, comprenant : au moins sur un côté de la carte de circuit imprimé une zone d'isolement (140, 140' ; 240, 240') qui réalise un entrefer et une ligne de fuite entre les pistes conductrices (120, 120' ; 220, 220') disposées sur la carte de circuit imprimé (100, 100' ; 200, 200') et la circonférence extérieure de la carte de circuit imprimé (100, 100' ; 200, 200'), **caractérisée en ce qu'**au moins une des zones d'isolement (140, 140' ; 240, 240') comporte un moyen à rainure et languette (150, 160, 150', 160' ; 250, 260) qui peut être mis en prise avec un moyen à rainure et languette (150, 160, 150', 160' ; 250, 260) correspondant d'une autre carte de circuit imprimé (100, 100' ; 200, 200') de telle sorte que les zones d'isolement (140, 140' ; 240, 240') respectives réalisant les entrefers et lignes de fuite se chevauchent au moins partiellement.

2. Carte de circuit imprimé (100, 100' ; 200, 200') selon la revendication 1, **caractérisée en ce que** la zone d'isolement (140, 140' ; 240, 240'), réalisant l'entrefer et la ligne de fuite entre les pistes conductrices (120, 120' ; 220, 220') disposées sur la carte de circuit imprimé (100, 100' ; 200, 200') et la circonférence extérieure de la carte de circuit imprimé (100, 100' ; 200, 200'), est comprise entre 1 mm et 5 mm.

3. Carte de circuit imprimé (100, 100' ; 200, 200') selon l'une des revendications 1 ou 2, **caractérisée en ce que** la languette (150, 150' ; 250) et/ou la rainure (160, 160' ; 260) du moyen à rainure et languette (150, 160, 150', 160' ; 250, 260) présentent, du côté frontal de la carte de circuit imprimé comportant le moyen à rainure et languette correspondant à la piste conductrice (120, 120' ; 220, 220'), une largeur entre 1 mm et 5 mm.

4. Carte de circuit imprimé (100, 100'; 200, 200') selon l'une des revendications précédentes, **caractérisée en ce que,** de la piste conductrice (120, 120' ; 220, 220'), la plus proche, de la carte de circuit imprimé (100, 100' ; 200, 200') au moyen à rainure et languette voisin, la zone d'isolement (140, 140' ; 240, 240') comporte une zone de protection (S, S') pour éviter un endommagement mécanique de la piste conductrice (120, 120' ; 220, 220') correspondante.

5. Carte de circuit imprimé (100, 100' ; 200, 200') selon l'une des revendications précédentes, **caractérisée en ce que** les moyens à rainure et languette (150, 160, 150', 160') sont constitués en gradins, la languette (150, 150') et la rainure (160, 160') comprenant respectivement la moitié de la section transversale de carte de circuit imprimé ou respectivement de l'épaisseur de la carte de circuit imprimé.

6. Carte de circuit imprimé (100, 100' ; 200, 200') selon l'une des revendications précédentes, **caractérisée en ce que** les moyens à languette et rainure (250, 260) de deux cartes de circuit imprimé (100, 100' ; 200, 200') raccordées sont en prise les uns avec les autres de telle sorte qu'un déplacement vertical et/ou horizontal des cartes de circuit imprimé (100, 100' ; 200, 200') raccordées est empêché.

7. Carte de circuit imprimé (100, 100' ; 200, 200') selon l'une des revendications précédentes, **caractérisée en ce que,** en vue de dessus, la carte de circuit imprimé (100, 100' ; 200, 200') présente une forme essentiellement rectangulaire.

8. Carte de circuit imprimé (100, 100' ; 200, 200') selon l'une des revendications précédentes, **caractérisée en ce que** des moyens à rainure et languette (150, 160, 150', 160' ; 250, 260) sont prévus sur au moins deux côtés de la carte de circuit imprimé (100, 100' ; 200, 200').

9. Carte de circuit imprimé (100, 100' ; 200, 200') selon la revendication 8, **caractérisée en ce que** des moyens à rainure et languette (150, 160, 150', 160' ; 250, 260) sont prévus sur tous les côtés de la carte de circuit imprimé (100, 100' ; 200, 200').

10. Carte de circuit imprimé (100, 100' ; 200, 200') selon l'une des revendications précédentes, **caractérisée en ce que,** sur au moins un des moyens à rainure et languette (150, 160, 150', 160' ; 250, 260), il est prévu des moyens d'encliquetage qui peuvent s'encliqueter avec un moyen d'encliquetage correspondant d'un moyen à rainure et languette (150, 160, 150', 160' ; 250, 260) correspondant d'une autre carte de circuit imprimé (100, 100' ; 200, 200').

11. Carte de circuit imprimé (100, 100' ; 200, 200') selon l'une des revendications précédentes, **caractérisée en ce que** la carte de circuit imprimé (100, 100' ; 200, 200') n'est pas une carte de circuit imprimé flexible.

12. Ensemble de cartes de circuit imprimé, comprenant au moins deux cartes de circuit imprimé (100, 100' ; 200, 200') selon l'une des revendications 1 à 11, dans lesquelles des moyens à rainure et languette (150, 160, 150', 160' ; 250, 260) correspondants sont en prise les uns avec les autres de telle sorte que les zones d'isolement (140, 140' ; 240, 240') respectives réalisant les entrefers et lignes de fuite se chevauchent au moins partiellement.

13. Ensemble de cartes de circuit imprimé selon la revendication 12, l'entrefer et la ligne de fuite, formés par les au moins deux cartes de circuit imprimé (100, 100' ; 200, 200'), des zones d'isolement (140, 140' ; 240, 240'), qui se chevauchent, entre les pistes conductrices (120, 120' ; 220, 220') des au moins deux cartes de circuit imprimé (100, 100' ; 200, 200') sont égaux à 1 mm et 5 mm.

14. Moyen d'éclairage, comprenant un ensemble de cartes de circuit imprimé selon l'une des revendications 12 ou 13, les cartes de circuit imprimé comportant respectivement au moins un moyen lumineux.
